# EUROPEAN PATENT APPLICATION

(11) **EP 1 892 765 A1**
(43) Date of publication of application: **27.02.2008**
(21) Application number: 06119425.4
(22) Date of filing: 23.08.2006
(51) Int. Cl.: H01L 29/786, H01L 21/336

(54) **METHOD FOR DOPING A FIN-BASED SEMICONDUCTOR DEVICE**

(71) Applicant: INTERUNIVERSITAIR MICROELEKTRONICA CENTRUM vzw (IMEC), 3001 Leuven (BE)
(72) Inventor: Kottantharayil, Anil, 3000, LEUVEN (BE)
(74) Representative: pronovem

(57) **Abstract**

A method is disclosed for doping a multi-gate device. The method includes patterning a fin in a substrate, depositing a gate stack, and doping the fin. The step of doping the fin is done by depositing a blocking mask material at least on the top surface of the fin after the patterning of the gate stack. After the deposition of the blocking mask material dopant ions are implanted whereby the blocking mask material partially or completely blocks the top surface of the fin from these dopant ions.

## Description

### Field of the Invention

The present invention is related to the field of semiconductor devices. More particularly this invention is related to the field of fin-based devices such as multi-gate devices and in particular to a method for doping such multi-gate devices.

### Background of the Invention

Scaling down of silicon MOS devices has become a major challenge in the semiconductor industry. Whereas at the beginning device geometrical shrinking already gave a lot of improvements in IC performance, nowadays new techniques, methods, materials and device architectures have to be introduced beyond the 90 nm technology node.

One major problem when scaling conventional planar devices are the short channel effects which start to dominate over the device performance. A solution for this problem came with the introduction of multi-gate field effect transistors (MUGFET), a fin-based realization of such devices referred to as FINFETs. Due to their three dimensional architecture, with the gate wrapped around a thin silicon fin, an improved gate control (and thus less short channel effects) over the channel could be achieved by using multiple gates.

An important issue for the fabrication of these FinFETs is the uniform doping of the source-drain extensions. For conventional planar devices source-drain extensions can easily be performed by doing ion implantation. In this way source-drain regions can be made in the plane of the wafer surface. For FinFETs however the doping of the source-drain extensions has to be done in a three dimensional way. More particularly doping of the top surface and doping of the sidewalls of the fin is necessary. This is typically done by applying two ion implantation steps, as also described in U.S. patent application US2004/0217433. In a first step dopant ions are implanted at a tilt angle α with respect to the normal to the top surface of the semiconductor fin in order to dope the first sidewall surface and the top surface. In a second step dopant ions are implanted at a tilt angle α with respect to the normal to the top surface of the semiconductor fin in order to dope the second sidewall surface and the top surface. Since the top of the fin receives the implant in both the steps described above, the implanted dose at the top of the fin versus the implanted dose at the sidewalls of the fin is always non-uniform. In addition the equivalent energy is different on the top and on the side of the fin except when a tilt angle of 45 degrees is used. More particularly, with the method as described in US2004/0217433 the top surface of the fin will receive twice the dose compared to the dose received at the sidewalls of the fin. This results in source-drain extension junctions which are not uniform (or conformal) all around the fin. More specifically, the doping ratio, which is the doping at the top surface versus the doping at the sidewall surfaces, is x:1, where x is equal to or greater than 2. This is not optimal for the device performance and short channel effect control. To obtain an optimal device performance, the ratio of sheet resistance of the top of the fin and the sheet resistance of the side walls should be close to 1.

Furthermore for 32 nm high density circuits, these extension implantations are limited to a tilt angle around or smaller than 10 degrees, which makes it again more difficult to get a uniform doping profile all along the fin.

It is a purpose of this invention to provide a method for doping a fin-based semiconductor device that overcomes the disadvantages as described above. More particularly it is the aim of the present invention to achieve a sheet resistance ratio at the top surface to the sidewall surfaces which is close to 1.

### Summary of the Invention

Method for doping a multi-gate device comprising the steps of patterning at least one fin in a substrate, said fin comprising a top surface and two sidewall surfaces, depositing a gate stack over the fin, patterning said gate stack over said fin, doping said fin characterized in that it further comprises the step of depositing a blocking mask material on at least part of the top surface of said fin after the step of patterning said gate electrode, implanting said fin with dopant ions at an incident angle with respect to the normal of the top surface of said fin whereby said blocking mask material partially or completely blocks the top surface of said fin from said dopant ions.

In a preferred embodiment of the present invention a blocking mask material is deposited on at least the whole top surface of said fin after the step of patterning said gate electrode.

In a preferred embodiment of the present invention said method for doping a multi-gate device further comprises the step of removing said completely or partially blocking mask material after said implanting step.

In a preferred embodiment of the present invention said step of implanting said fin comprises a first implantation step with said dopant ions at a first incident angle with respect to the normal of the top surface of said fin whereby said blocking mask material partially or completely blocks the top surface of said fin from said dopant ions and a second implantation step with said dopant ions at the opposite incident angle of said first incident angle with respect to the normal of the top surface of said fin whereby said blocking mask material partially or completely blocks the top surface of said fin from said dopant ions.

Advantageously, said blocking mask material partially blocks the top surface of said fin from said dopant ions such that the ratio of the resistance on said top surface to the resistance on said sidewall surfaces of said fin is close to 1 after said implanting step.

In another preferred embodiment of the present invention, if said blocking mask material completely blocks the top surface of said fin from said dopant ions, the method further comprises the step of implanting said top surface of said fin with dopant ions after removing said completely blocking mask material such that the ratio of the resistance on said top surface to the resistance on said sidewall surfaces of said fin is close to 1 after said step of implanting said top surface.

In a preferred embodiment of the present invention said step of implanting said top surface is done perpendicular to said top surface of said fin.

In a preferred embodiment of the present invention said blocking mask material blocks said dopant ions depending on the density and the thickness of said blocking mask material.

In a preferred embodiment of the present invention said blocking mask material has a thickness which is greater than 5 nm.

In a preferred embodiment of the present invention said incident angle is determined by the thickness of said blocking mask material.

In a preferred embodiment of the present invention said incident angle is within the range of about 0 degrees to about 20 degrees with respect to the normal of said top surface of said fin.

In a preferred embodiment of the present invention said blocking mask material is chosen from amorphous carbon, oxide or nitride.

In a preferred embodiment of the present invention said blocking mask material is deposited on at least the top surface of said fin using a line of sight deposition technique.

In a preferred embodiment of the present invention said line of sight deposition technique is chosen from CVD or PECVD or MBE or sputtering.

In a preferred embodiment of the present invention said dopant ions are selected from the group consisting of B, As, P, Sb, BF3.

In a preferred embodiment of the present invention said step of patterning at least one fin further comprises providing an array of fins located at an inter-fin distance from each other.

In a preferred embodiment of the present invention said step of doping the fin is achieved by plasma doping technology or by ion implantation.

Also a multi-gate device is disclosed obtainable with the method of the present invention. By applying the method of the present invention for doping a multi-gate device a uniform doping around the channel region of the fin can be achieved such that the ratio of the resistance on said top surface to the resistance on said sidewall surfaces of said fin is close to 1 after said implanting step.

### Description of the Drawings

All drawings are intended to illustrate some aspects and embodiments of the present invention. The drawings described are only schematic and are non-limiting.

Exemplary embodiments are illustrated in referenced figures of the drawings. It is intended that the embodiments and figures disclosed herein be considered illustrative rather than restrictive.

Figure 1 is a schematic overview of one fin and the associated fin geometry parameters.

Figure 2 represents a schematic overview of at least one fin (two fins) and the associated fin geometry parameters.

Figure 3 is a 3-dimensional schematic overview of an example of a multi-gate device from the present invention.

Figure 4 gives a cross-sectional view of the method of the present invention.

Figure 5 are SEM images of a blocking mask material deposited on an array of fins.

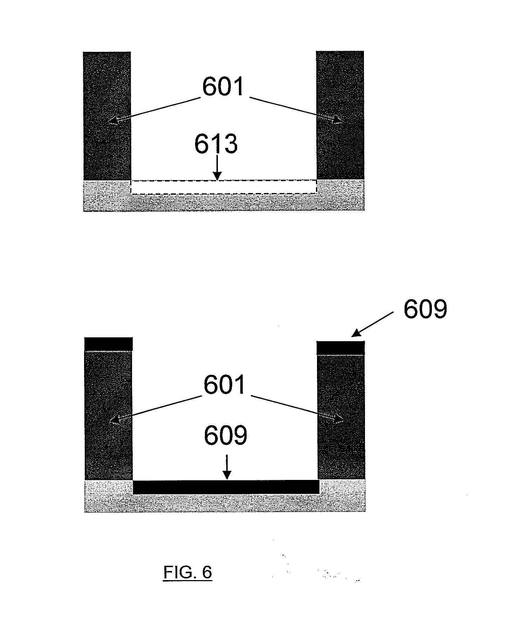

Figure 6 gives an overview of the ion implant range in function of a blocking mask material and its thickness and density.

Figure 7 gives a schematic overview of the method of the present invention where a completely blocking mask material is used for doping at least one fin.

Figures 8 and 9 give a schematic overview of the method of the present invention where a partially blocking mask material is used for doping at least one fin.

Figure 10 gives the ratio of sheet resistance at the top surface to the sidewall surface for different tilt angles and different hardmask densities.

### Detailed Description of the Invention

One or more embodiments of the present invention will now be described in detail with reference to the attached figures, the invention is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the invention. Those skilled in the art can recognize numerous variations and modifications of this invention that are encompassed by its scope. Accordingly, the description of preferred embodiments should not be deemed to limit the scope of the present invention.

Furthermore, the terms first, second and the like in the description and in the claims are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the invention described herein can operate in other orientations than described or illustrated herein. For example "underneath" and "above" an element indicates being located at opposite sides of this element.

It is to be noticed that the term "comprising", used in the claims, should not be interpreted as being restricted to the means listed thereafter; it does not exclude other elements or steps. Thus, the scope of the expression "a device comprising means A and B" should not be limited to devices consisting only of components A and B. It means that with respect to the present invention, the only relevant components of the device are A and B.

The term "blocking mask material" as referred to in this application is used to define a mask material which blocks the dopant ions completely or partially during the implantation step. If the mask material completely blocks the dopant ions, the dopant ions cannot pass through said mask material and can thus not reach the surface directly under said mask material. This means the surface located directly under said mask material will not be doped by said dopant ions. If the mask material partially blocks the dopant ions, some of the dopant ions pass through the said mask material whereas some others can not pass through the said mask material. This means the surface located directly under said mask material will be doped by said partially passed through dopant ions.

The term "blocking factor" as referred to in this application is used to define the ratio of the doping concentration the surface gets when a blocking mask material is used during the implantation step with dopant ions of said surface to the doping concentration the surface gets when no mask material is used during the implantation step with dopant ions of said surface. If a blocking mask material is used which completely blocks the dopant ions, the blocking factor is zero since no dopant ions can reach the top surface of said fin due to the completely blocking mask layer. As soon a partially blocking mask material is used, the blocking factor becomes greater than zero. If no blocking mask material is used, the blocking factor is 1, since all dopant ions will reach the top surface of the fin.

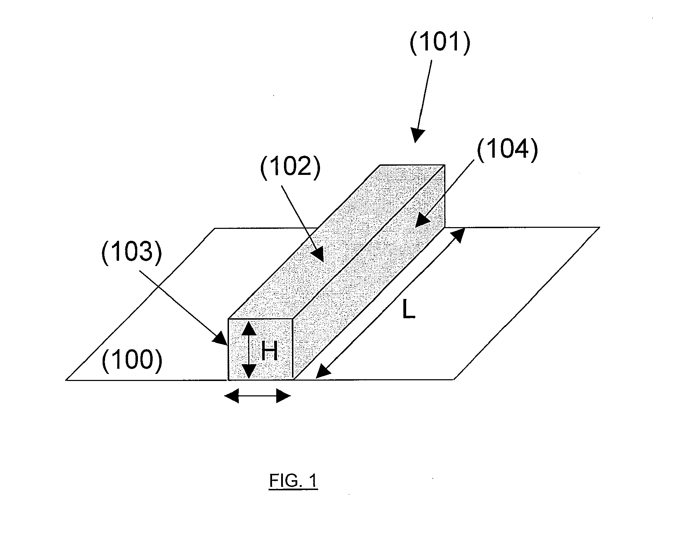

A planar field effect transistor consists of a channel which is in the plane of the wafer surface and a gate which is located on top of this wafer surface in the same plane as the channel. The present invention is related to fin-based field effect transistors. For fabricating a fin-based field effect transistor, a semiconductor material (e.g. Si, SiGe, Ge, III-V material, GaAs,...) is patterned to form a fin-like shaped body. Due to this fin-shaped body a fin-based device is also often referred to as a FinFET device. As described in fig. 1, the fin (101) is raised above the wafer/substrate surface (100). The fin (101) is determined by its width (W), height (H) and length (L) and comprises a top surface (102), a first (left) sidewall surface (103) and a second (right) sidewall surface (104). A gate electrode is wrapped on the channel region of the fin. Depending on the shape of the gate electrode, different types of finfet devices can be defined. A double-gate finfet is a finfet device where the gate only controls the conductivity of the two sidewall surfaces of the fin. A multi-gate device (MUGFET) is a fin-based device where the gate controls the conductivity of the two sidewall surfaces and the top surface and/or bottom surface of the fin. For example, an omega-gate finfet (Ω-gate finfet) is a multi-gate device where the gate controls the conductivity of the two sidewall surfaces and the top surface of the fin. An U-gate finfet is a multi-gate device where the gate controls the conductivity of the two sidewall surfaces and the bottom surface of the fin. A round-gate finfet is a multi-gate device where the gate controls the conductivity of the two sidewall surfaces, the top surface of the fin and the bottom surface of the fin.

A FinFET or a MUGFET can be fabricated on a semiconductor-on-insulator substrate (SOI). SOI substrates can be made in different ways, such as separation by implanted oxygen (IMOX) or wafer bonding. Examples may be silicon-on-insulator, strained silicon-on-insulator substrates (SSOI) or relaxed Si₁₋ₓGeₓ-on-insulator (SGOI). Alternatively a FinFET/MUGFET can also be fabricated on bulk semiconductor material and is then referred to as bulk FinFET/MUGFET.

The present invention provides a method for doping a multi-gate device comprising the steps of patterning at least one fin in a substrate, each fin comprising a top surface and two sidewall surfaces, depositing a gate stack over said fin, patterning said gate stack, doping said fin characterized in that it further comprises depositing a blocking mask material on at least the top surface of said fin after the step of depositing said gate stack implanting said fin with dopant ions at an incident angle with respect to the normal of the top surface of said fin whereby said blocking mask material partially or completely blocks the top surface of said fin from said dopant ions.

In a first step of the method of the present invention, at least one fin is patterned in the substrate by using a photolithographic step or by using spacer technology for patterning spacer defined fins. The fin (101) has a width (W), a height (H) and a length (L). The fin comprises a top surface (102) and two sidewall surfaces (103,104). More specifically a first (left) sidewall surface (103) and a second (right) sidewall surface (104) are defined. As example for a 32 nm technology node device, the fin width is about 10 nm to 20 nm and the fin height is about 60 nm.

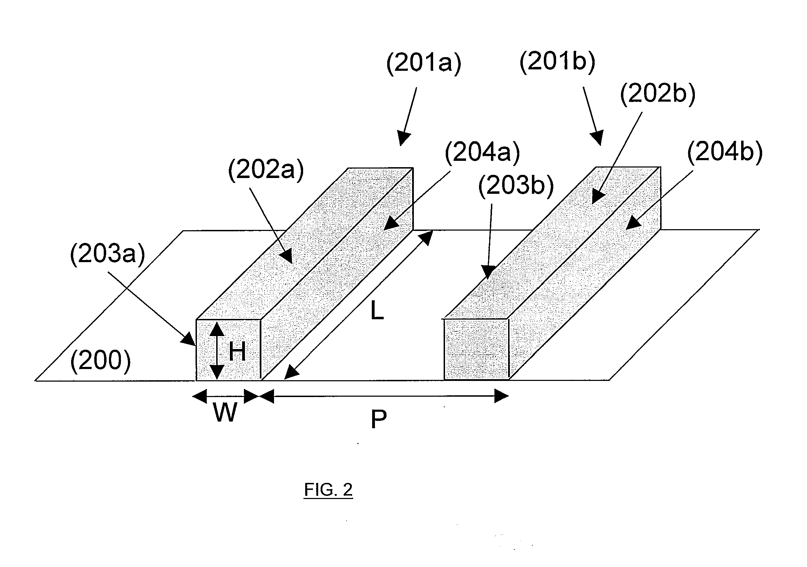

In a preferred embodiment of the present invention a plurality of fins is patterned in the substrate by using a photolithographic step or by using spacer technology for patterning spacer defined fins. As described in fig. 2, said plurality of fins comprises at least two fins (201a, 201b) with an inter-fin distance also often referred to as fin pitch (P). Each fin has a fin width (W), a fin height (H) and a fin length (L). Each fin comprises a top surface (202a, 202b) and two sidewall surfaces (203a, 203b, 204a, 204b). Said two sidewall surfaces of each fin consist of a first (left) sidewall surface (203a, 203b) and a second (right) sidewall surface (204a, 204b). For example for a 32 nm technology node, the fin width is preferably between 10 nm and 20 nm, the fin height is preferably 60 nm and the fin pitch is preferably 100 nm.

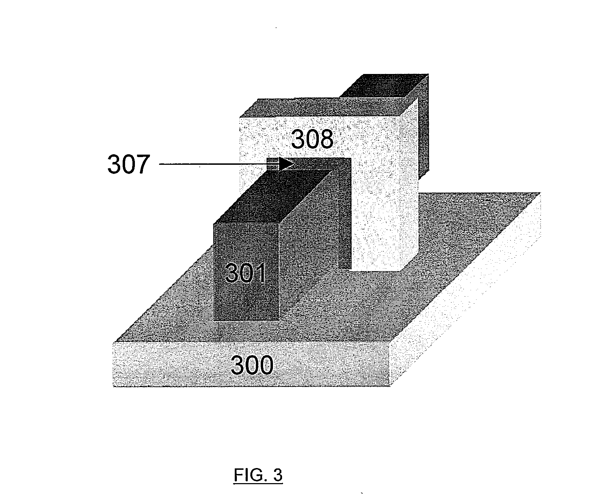

In a second step of the method of the present invention, following the patterning of said at least one fin (301), a gate stack may be deposited over said at least one fin. Said gate stack consists of a gate dielectric material (307) and a gate electrode material (308). Following the deposition of the said gate stack, it may be patterned over said at least one fin, as represented in fig. 3. Said gate dielectric material (307) is chosen from e.g. silicon oxide, silicon nitride, high-k material or other dielectric materials known for a person skilled in the art. The thickness of said gate dielectric material is preferably in the range of 10 Å to 20 Å and can be deposited by a CVD technique or any other deposition technique known for a person skilled in the art. Said gate dielectric material covers at least the top surface and the two sidewall surfaces of said fin.

Said gate electrode material (308) is chosen from e.g. undoped polycrystalline silicon, silicon germanium or any other conductive material, e.g. metals, known for a person skilled in the art, such as TiN, Ta(Si)N, NiSi, Ir, Pd, Ni, Mo, MoN, Pt, RuO₂, CrSi₂, MoSi₂,.... Said gate electrode material can be deposited by a CVD technique or any other deposition technique known for a person skilled in the art. Said gate electrode material covers said gate dielectric material and thus at least the top surface and the two sidewall surfaces of said fin. The deposition may be followed by a developing and etching step to pattern the gate electrode.

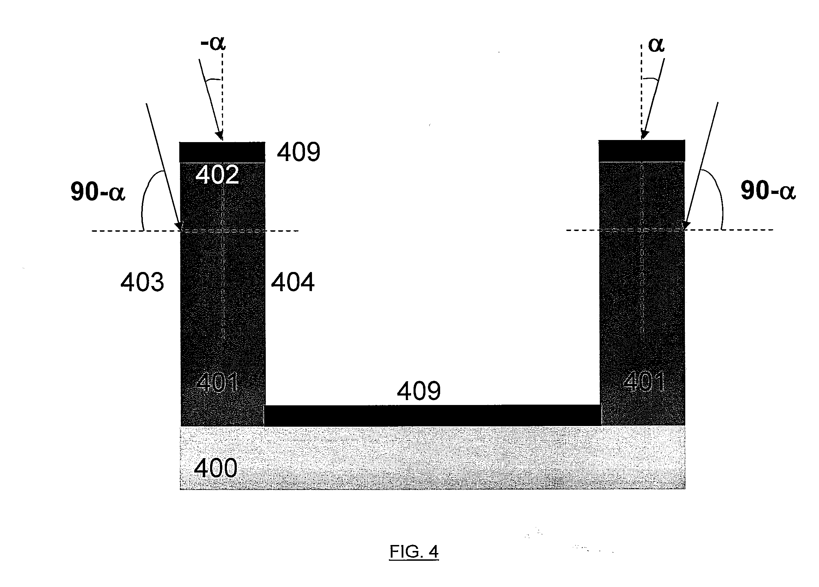

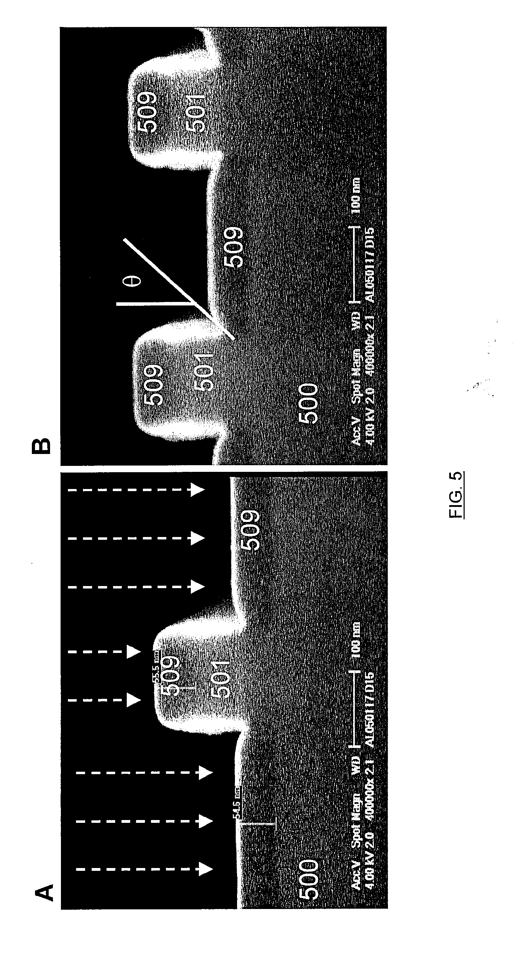

In a third step of the present invention, as described in fig. 4, a blocking mask material (409) is deposited at least on the top surface (402) of said at least one fin. The mask material is not deposited on the sidewall surfaces (403, 404) of said fin. Additionally said blocking mask material (409) may be deposited on the substrate at both sides next to said fin or in case a plurality of fins is patterned in between successive fins. Said blocking mask material (409) serves as a blocking material to completely or partially block the dopant ions in the subsequent implantation step. Said blocking material may be preferably deposited by any line-of-sight deposition technique such as e.g. MBE, CVD, PECVD, sputtering. With a line-of-sight deposition technique is meant a technique for which deposition only occurs in the line-of-sight from the source, as shown also in figure 5 with the dashed arrows. By using a line-of-sight deposition said blocking material will not be deposited on the sidewall surfaces of said at least one fin. Said blocking material will be deposited at least on the top surface of said fin. If a plurality of fins is patterned, said blocking mask material will be present on the top surface of the fins and on the substrate/wafer surface in between said successive fins. Said blocking material is chosen from any material that can be deposited by a line-of-sight deposition technique or any other material which can completely or partially block dopant ions known for a person skilled in the art. For example amorphous carbon hard mask material can be used for this blocking mask material. Figure 5A is a microscopy image (scanning electron microscopy) showing one isolated fin (501) on which an amorphous carbon hard mask material (509) is deposited using PECVD. By using this line-of-sight deposition technique the amorphous carbon hardmask is deposited on the top surface of the fin and on the wafer surface at both sides next to the fin (509). No material is deposited on the sidewalls of the fin. The thickness of the amorphous carbon hard mask material is about 55 nm. Figure 5B is a microscopy image (scanning electron microscopy) showing a plurality of fins (e.g. two fins) on which an amorphous carbon hard mask material is deposited using PECVD. The fin height is approximately 100 nm, the fin width is approximately 100 nm and the fin pitch is approximately 250 nm. By using this line-of-sight deposition technique the amorphous carbon hardmask is deposited on the top surface of the fin and on the substrate/wafer surface in between successive fins. No material is deposited on the sidewalls of the fin. The thickness of the amorphous carbon hard mask film is about 55 nm. For dense structures, it would be possible to limit the deposition of the blocking material in between the successive fins by tuning the deposition process parameters.

In figure 5B, an angle θ is visible at the bottom of the fin between the sidewall of the fin and the deposited mask material. Doping of the bottom part of the fin can be ensured as long as the implant angle is much smaller than the angle θ. The angle θ is measured to be in the range of 50 degrees for dense fins to 70 degrees for isolated fins. Since the implant angle of dopant ions is much smaller, e.g. 10 degrees for a 32 nm technology node, the bottom part of the fins will be doped without any problem.

The thickness of the blocking mask material should preferably be thicker than 5 nm. If the thickness of the blocking mask material is too thick, the bottom of the fin cannot be doped. A box recess (613) can be etched (using f.e. a dry etch) in the substrate in between the fins (601). In a next step the blocking mask material (609) is deposited in said box recess. With this method the thickness of the blocking mask material may be chosen thicker (f.e. 30 nm). This facilitates the doping of the bottom of the fin in the subsequent implantation steps since almost all blocking mask material will be located in the box recess.

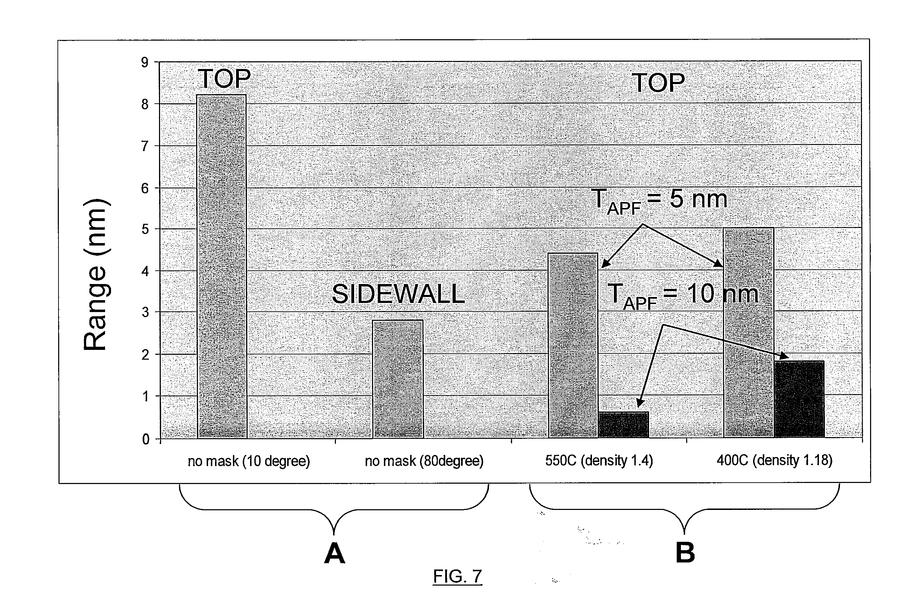

Depending on the blocking factor of this blocking mask material, the thickness and density of this blocking mask material may be scaled. Figure 7 shows some analytical simulations where different thickness and different density for the blocking mask material are used (e.g. amorphous carbon hardmask). The doping range is plotted in function of the top surface and sidewall surface for different thickness and different density of blocking mask material. The doping range means the depth of said top surface and said sidewall surface into the fin which is doped. To dope the fin, an implantation of Arsenic is simulated at a doping energy of 5 keV with an implantation tilt angle of 10 degrees with respect to the normal to the top surface of the fin. Figure 7A shows the results for an implantation done without using a (blocking) hardmask material. In this case the blocking factor is 1 since all the dopant ions will reach the top surface. In this case the top surface receives more than double of the dose as the sidewall surface, which leads to a non-uniform doping profile along the fin. Figure 7B shows the results for an implantation done using a partially blocking hardmask material. With a density of said hardmask material of 1.4 g/cm³ and a thickness of said hardmask material of 5 nm, the doping range becomes much smaller compared to the doping range received at the top surface of the fin without using a hardmask material. By decreasing the density of the hardmask material to e.g. 1.18 g/cm³ an increase is seen in the doping range at the top surface compared to the higher density. This is explained due to the fact that a denser material will block the dopant ions more compared to a less dense material. When depositing a thicker film of said hardmask material a further decrease is occurring of the doping range measured at the top surface of said fin. This is explained by the fact that a thicker film will block the dopant ions more compared to using a thinner film. Preferably for an implantation of Arsenic at a doping energy of 5 keV with a implantation tilt angle of 10 degrees with respect to the normal of the top surface of the fin, an amorphous carbon hardmask film is deposited with a thickness in the range of 5 to 10 nm and a density in the range of 1.2 and 1.5 g/cm³

In a next step of the present invention the fin or the plurality of fins are doped by a tilt angle implantation. Said fins may be doped with n-type, e.g. Arsenic, Phosphorus or may be doped p-type impurities, e.g. Boron. The impurities are implanted at a tilt angle below 90 degrees with respect to the normal of the top surface of said fin. For example for a 32 nm technology node a tilt angle of 10 degrees or smaller is used to dope the fin. The implantation dosage and the implantation energy used to implant the fin with dopant impurities is dependent on the desired dopant profile, the fin height, the fin pitch, the fin width, the thickness of the blocking mask material. When doping the fin with a tilt angle, e.g. an angle different from zero with respect to the normal of the top surface, two implantation steps are necessary. In a first implantation step the left sidewall surface and the top surface of the fin or the plurality of fins is doped with a tilt angle -α. In a second implantation step the right sidewall surface and the top surface of the fin or the plurality of fins is doped with a tilt angle α. For both implantation steps the tilt angle is the same in absolute value and is symmetrical.

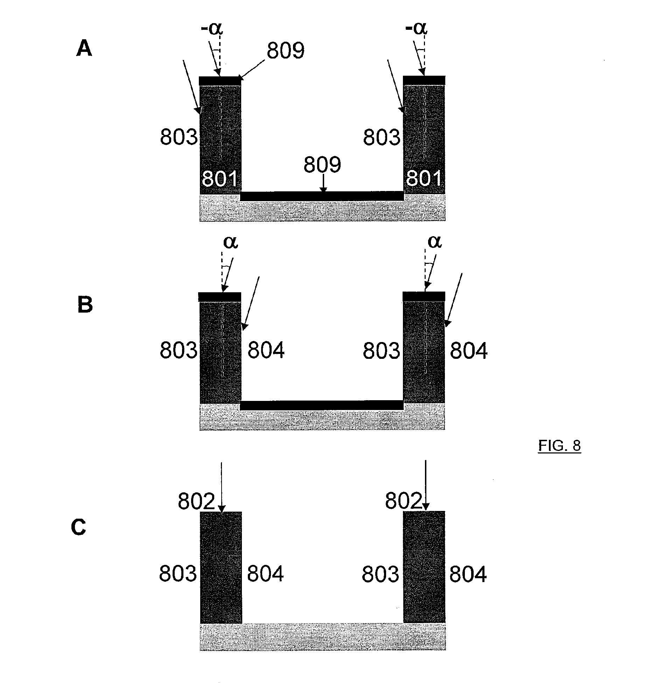

In preferred embodiment of the present invention a completely blocking mask material (809) is deposited at least on the top surface of a fin or a plurality of fins. After the deposition of the completely blocking mask material, the left sidewall surface (803) of the fin or the plurality of fins is doped by performing a first implantation step at a tilt angle -α (figure 8A). Next a second implantation step (figure 8B) is done at the opposite tilt angle α to dope the right sidewall surface (804) of the fin or the plurality of fins. After removal of the completely blocking hardmask material the top surface is implanted by a third implantation step (figure 8C) by using an implantation angle which is perpendicular to the top surface (802) of said fin. By using the method as described in this preferred embodiment a sheet resistance ratio close to 1 can be achieved between the sheet resistance achieved at the top surface of the fin and the sheet resistance achieved at the sidewall surfaces of the fin. Preferably a sheet resistance ratio in between 0.8 and 1.4 is achieved. After said implantation steps the blocking hardmask material may be removed. The removal of the hardmask material may be done for example by dry etching or any other suitable etching method.

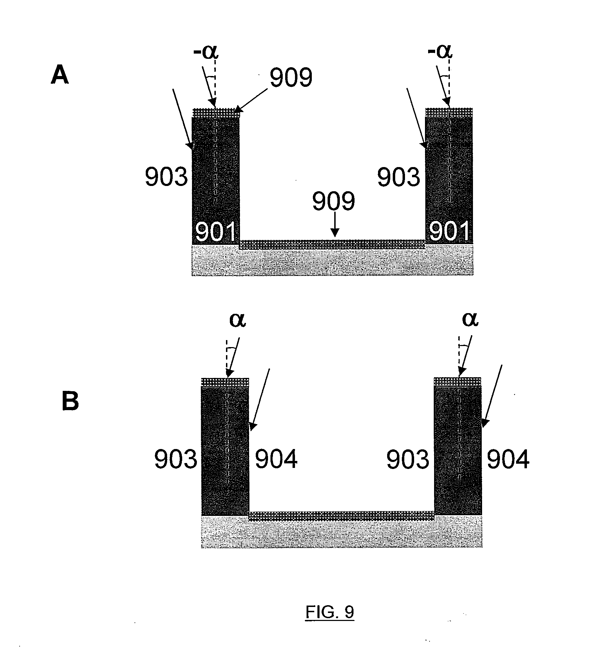

In another preferred embodiment of the present invention a partially blocking mask material (909) is deposited at least on the top surface of a fin or a plurality of fins (figure 9A). After the deposition of the partially blocking mask material, the left sidewall surface (903) of the fin (901) or the plurality of fins is doped by performing a first implantation step at a tilt angle -α. After this implantation step the left sidewall surface of the fin is implanted as well as the top surface (902) which is only partially blocked by the blocking mask material. By choosing the appropriate parameters for the blocking mask material (e.g. thickness, blocking factor, density) the doping ratio will be close to 0.5 after this first implantation step. Next a second implantation step (figure 9B) is done at the tilt angle α to dope the right sidewall surface of the fin or the plurality of fins. After this implantation step the right sidewall (904) surface of the fin is also implanted as well as the top surface (902) which is only partially blocked by the blocking mask material. By using these two subsequent implantation steps a uniform doping profile is achieved along the fin. This means that the sheet resistance ratio of the top surface to the sidewall surfaces will be close to 1. Preferably the sheet resistance is in the range of 0.8 to 1.4. The step of implanting the fin can be done using ion implantation or plasma doping (PLAD).

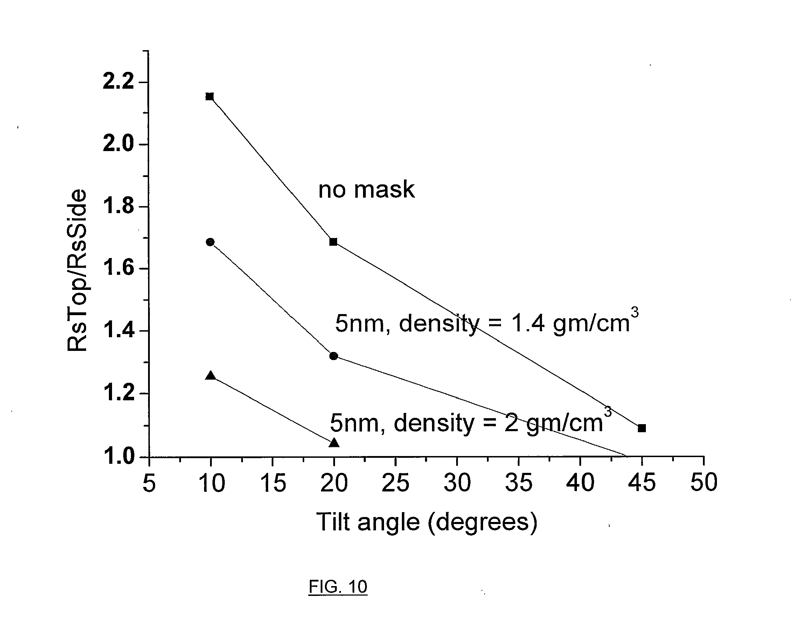

In figure 10 the ratio of the sheet resistance of the top surface to the sidewall surfaces is calculated for different implantation tilt angles and different hardmask material densities. Ideally, if the doping would be uniform along the fin, a ratio of 1 is measured. This means the doping (resistance) at the top surface is equal to the doping (resistance) at the sidewall surfaces. When using no mask material a ratio of more than 2 is measured when using small tilt angles. For example for a 32 nm technology node a tilt angle lower than 10 degrees is necessary and thus the implantation without using a mask is not satisfactory to achieve a uniform doping as is known from the prior art. When using a 5 nm thick partially blocking mask material with a density of 1.4 gr/cm³, the ratio of the sheet resistance between top surface and sidewall surfaces can be decreased to values lower than 2 and thus gets closer to the ideal value of 1. When using a higher density (e.g. 2 gr/cm³) of the blocking mask material even a ratio can be achieved very close to 1.

The present invention for doping a multi-gate device can be employed to fabricate a multi-gate device with a uniform doping around the channel region of the fin, i.e. such that the ratio of the resistance on said top surface of the fin to the resistance on said sidewall surfaces of the fin is close to 1 after the implanting step. Said multi-gate device comprises at least one fin comprising a top surface, two sidewall surfaces and a bottom surface, a gate dielectric and gate electrode around said fin covering at least part of said top surface of said fin, a source and drain region, a channel region in between said source/drain region for which the ratio of the resistance in the channel on the top surface of the fin to the resistance in the channel on the sidewall surfaces of the fin is close to 1. Said multi-gate device may further comprise spacers, isolation regions in between different fins and interconnect regions. These regions may be fabricated following the fabrication process known for a person skilled in the art.

## Claims

1. Method for doping a multi-gate device comprising the steps of:
patterning at least one fin in a substrate, each fin comprising a top surface and two sidewall surfaces,
patterning a gate electrode over said fin,
doping said fin,
**characterized in that** it further comprises the steps of:
depositing a blocking mask material on at least part of the top surface of said fin after the step of depositing said gate electrode,
implanting said fin with dopant ions at an incident angle different from zero with respect to the normal to the top surface of said fin whereby said blocking mask material partially or completely blocks the top surface of said fin from said dopant ions.

2. Method for doping a multi-gate device according to claim 1 wherein said step of depositing a blocking mask material on at least part of the top surface of said fin after the step of depositing said gate electrode further comprises depositing a blocking mask material on at least the whole top surface of said fin after the step of depositing said gate electrode

3. Method for doping a multi-gate device according to any one of the preceding claims, further comprising the step of removing said completely or partially blocking mask material after said implanting step

4. Method for doping a multi-gate device according to any one of the preceding claims, wherein said step of implanting said fin comprises a first implantation step with said dopant ions at a first incident angle with respect to the normal of the top surface of said fin whereby said blocking mask material partially or completely blocks the top surface of said fin from said dopant ions and a second implantation step with said dopant ions at the opposite incident angle of said first incident angle with respect to the normal of the top surface of said fin whereby said blocking mask material partially or completely blocks the top surface of said fin from said dopant ions.

5. Method for doping a multi-gate device according to any one of the preceding claims, wherein said blocking mask material partially blocks the top surface of said fin from said dopant ions such that the ratio of the resistance on said top surface to the resistance on said sidewall surfaces of said fin is close to 1 after said implanting step.

6. Method for doping a multi-gate device according to any one of the preceding claims, wherein said blocking mask material completely blocks the top surface of said fin from said dopant ions further comprising the step of implanting said top surface of said fin with dopant ions after removing said completely blocking mask material such that the ratio of the resistance on said top surface to the resistance on said sidewall surfaces of said fin is close to 1 after said step of implanting said top surface.

7. A method for doping a multi-gate device according to claim 6, wherein said step of implanting said top surface is done perpendicular to said top surface of said fin.

8. A method for doping a multi-gate device according to any one of the preceding claims, wherein said blocking mask material blocks said dopant ions depending on the density and the thickness of said blocking mask material.

9. A method for doping a multi-gate device according to any one of the preceding claims, wherein said blocking mask material has a thickness bigger than 5 nm.

10. A method for doping a multi-gate device according to any of the preceding claims, wherein said incident angle is within the range of about 0 degrees to about 20 degrees with respect to the normal of said top surface of said fin.

11. A method for doping a multi-gate device according to any one of the preceding claims, wherein said blocking mask material is amorphous carbon or oxide or nitride.

12. A method for doping a multi-gate device according to any one of the preceding claims, wherein said blocking mask material is deposited on at least the top surface of said fin using a line of sight deposition technique.

13. A method for doping a multi-gate device according to claim 12, wherein said line of sight deposition technique is chosen from MBE or CVD or PECVD or sputtering.

14. A method for doping a multi-gate device according to any one of the preceding claims, wherein said dopant ions are selected from the group consisting of P, As, B, Sb, BF3.

15. A method for doping a multi-gate device according to any one of the preceding claims, wherein said step if implanting said fin is done by ion implantation or by plasma doping (PLAD).

16. Method for doping a multi-gate device according to any one of the preceding claims, wherein said step of patterning at least one fin further comprises providing an array of fins located at an inter-fin distance from each other.
